# EUROPÄISCHE PATENTSCHRIFT

(11) **EP 0 812 001 B1**
(45) Veröffentlichungstag und Bekanntmachung des Hinweises auf die Patenterteilung: **15.10.2003**
(21) Anmeldenummer: 97106083.5
(22) Anmeldetag: 14.04.1997
(51) Int. Cl.: H01J 37/34, C23C 14/34, C23C 14/35, C23C 14/00

(54) **Vorrichtung zur Kathodenzerstäubung**
Cathodic sputtering device
Dispositif de pulvérisation cathodique

(30) Priorität: 13.04.1996 DE 19614599; 13.04.1996 DE 19614595
(43) Veröffentlichungstag der Anmeldung: 10.12.1997
(73) Patentinhaber: Singulus Technologies AG, 63755 Alzenau (DE)
(72) Erfinder: Sichmann, Eggo, 63571 Gelnhausen (DE)
(74) Vertreter: VOSSIUS & PARTNER

(56) Entgegenhaltungen:
- EP-A- 0 297 779
- EP-A- 0 558 797
- EP-A- 0 606 097
- DE-A- 3 338 377
- DE-A- 4 315 023
- US-A- 4 060 470
- US-A- 4 100 055
- US-A- 4 407 708

## Beschreibung

Die Erfindung bezieht sich auf eine Vorrichtung zur Kathodenzerstäubung für die Herstellung von Schichten auf einem Substrat mittels einer in einer Vakuumkammer einbringbaren Zerstäubungskathode, die mit Bezug auf die Mittelachse der Zerstäubungskathode konzentrisch angeordnete Magneten bzw. Ringmagneten, Polschuhe und ein Target aufweist, dessen Oberfläche mit Bezug auf die Targetrückseite zumindest teilweise geneigt verläuft.

Es ist bereits eine Vorrichtung zur Kathodenzerstäubung für die statische Beschichtung scheibenförmiger Substrate mittels eines Plasmas in einer Vakuumkammer mit mindestens einer Öffnung bekannt (DE 43 15 023 A1), welche durch Auflegen einer Zerstäubungskathode von außen verschließbar ist. Zwischen der Kathode und der Kammerwand sind ein elastischer Vakuumdichtring sowie eine ringförmige Anode vorgesehen, die die Öffnungen radial von außen umgeben, wobei die Anode auf ihrer zur Kathode hin zeigenden Seite eine ebene Kontaktfläche aufweist. Die bekannte Zerstäubungskathode besteht aus einem scheibenförmigen, ferromagnetischen Joch und einer Kühlplatte. Zwischen beiden ist ein scheibenförmiger Isolator eingelegt. Vor der Kühlplatte befindet sich das zu zerstäubende Target, während auf der Rückseite der Kühlplatte in einer Nut ein Ringmagnet eingelegt ist. Durch den Ringmagneten wird ein Gegenmagnetfeld erzeugt, welches den Verlauf der Magnetfeldlinien beeinflußt. Hierdurch erhält der Verlauf der Magnetfeldlinien einen annähernd parallelen bzw. linsenförmigen oder konvexen Verlauf.

Demgegenüber liegt der Erfindung die Aufgabe zugrunde, die Magneten derart anzuordnen oder das Magnetfeld derart zu gestalten, daß die Targetausbeute verbessert wird. Diese Aufgabe wird mit den Merkmalen der Patentansprüche gelöst.

Dabei geht die Erfindung von dem Grundgedanken aus, im Bereich der Targetrückseite mindestens einen zweiten äußeren Ringmagneten vorzusehen und/oder im Bereich des unteren Teils des Pohlschuhs eine Ringkammer vorzusehen, in der gegebenenfalls ein weiterer Ringmagnet vorgesehen werden kann. Durch diese Maßnahmen wird der Magnetfeldverlauf im Bereich der Zerstäubungskammer optimiert.

Somit, ist bei einer erfindungsgemäßen Lösung in Bereich der Targetrückseite neben dem ersten inneren Ringmagneten mindestens ein zweiter äußerer, im Durchmesser größerer Ringmagnet vorgesehen. Durch die Verwendung zweier Ringmagneten kann eine Verstärkung des Magnetfeldes und gleichzeitig in einem bestimmten Bereich der Kathode ein möglichst flacher Oberflächenverlauf der Magnetfeldlinien mit Bezug auf die Targetrückseite erreicht werden. Hierdurch wird eine noch bessere Targetausnutzung sichergestellt.

Der seitlich angebrachte Ringmagnet erzeugt das das Target durchdringende Sputtermagnetfeld.

Durch den Einbau der zusätzlichen Doppelringmagneten, die auch sehr dicht an die Targetrückseite herangebracht werden können, wird durch die horizontal verlaufenden Magnetfeldlinien ein möglichst breiter Erosionsgraben erzielt, da die Elektronen nicht auf enge Bereiche bzw. auf einem Ringkanal fokussiert werden. Deshalb ist es vorteilhaft, daß man eine große horizontale Komponente des Magnetfeldes erreicht, und durch den Einbau der Doppelringmagneten in die Rückwand der Kühlplatte erhält man einen sehr geringen Abstand zur Targetrückseite. Von besonderer Bedeutung ist auch die Targetkonfiguration und die Polschuhausbildung.

Durch die vorteilhafte Ausbildung des Targets mit einem flanschförmigen Teil in Verbindung mit einem einschraubbaren oder mittels Schraubenelementen feststellbaren Kühlfinger muß das Target nicht mehr aufgebondet, sondern kann nach Bedarf jederzeit ohne weiteres ausgewechselt werden.

Durch die geneigt verlaufende Anordnung des Targets und durch die sich daran anschließende, parallel verlaufende Targetoberfläche erhält man eine optimale Ausbildung des Targets, insbesondere wenn ein nichtferromagnetisches Metalltarget als Beschichtungsmaterial eingesetzt wird, da durch die vorteilhafte Anordnung der Ringmagneten im Außenbereich des Targets mehr Material abgesputtert wird als im inneren Bereich. Hierdurch erhält man also eine gleichmäßige Ausnutzung des Targets.

Weitere Vorteile und Einzelheiten der Erfindung sind in den Patentansprüchen und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Fig. 1: eine Schnittdarstellung eines Targets mit mehreren konzentrisch angeordneten Ringmagneten,

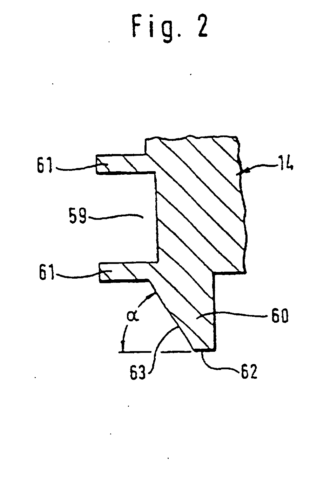

- Fig. 2: eine Teilansicht des Polschuhs gemäß Figur 1.

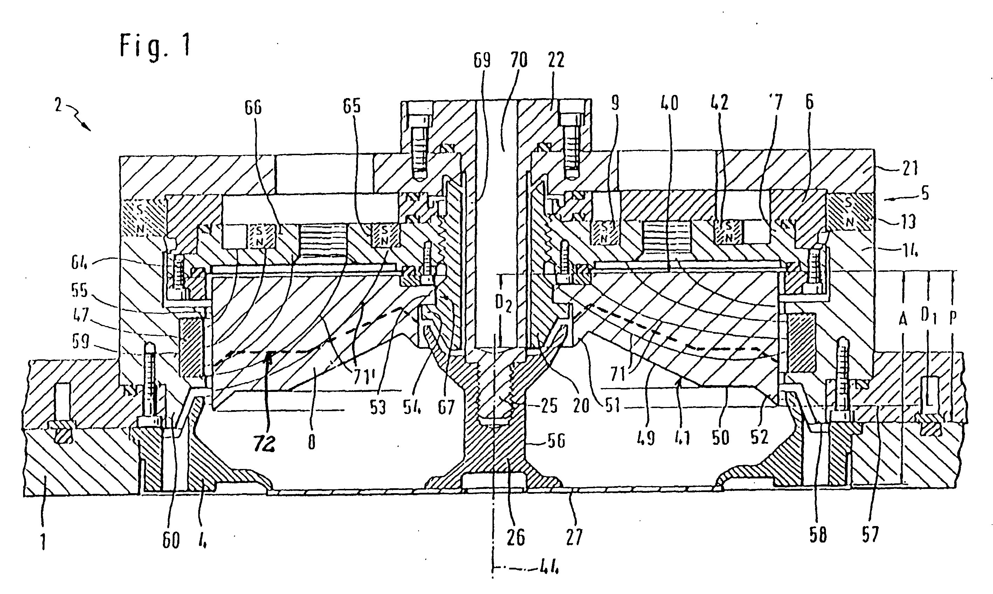

In Fig. 1 ist eine Vorrichtung zur Kathodenzerstäubung für die Herstellung von Schichten auf einem Substrat, beispielsweise einer Compact Disk 27, dargestellt. Für den Prozeßablauf kann die mit 2 bezeichnete Zerstäubungskathode in eine Kammerwand 1 der Vorrichtung zur Kathodenzerstäubung eingesetzt werden. Die Kathode besteht aus einem scheibenförmigen, ferromagnetischen Joch 5 und einer Kühlplatte 7. Zwischen dem. Joch 5 und der Kühlplatte 7 ist ein Isolator 6 6 eingeklemmt und mittels Schraubenbolzen gesichert.

Vor der Kühlplatte 7 ist ein zu zerstäubendes Target 8 angeordnet. Auf der Rückseite der Kühlplatte 7 befindet sich ebenfalls eine ringförmige Nut 66 und eine Ringnut 65 zur Aufnahme eines inneren Ringmagneten 9 und eines äußeren Ringmagneten 42, die konzentrisch zur Mittelachse 44 des Targets 8 angeordnet sind. Das Joch 5, der Isolator 6 und die Kühlplatte 7 werden durch eine in der Zeichnung nicht dargestellte Schraube gesichert. Die Schraube ist in vorteilhafter Weise durch einen Isolator gegen das Joch isoliert. An die Schraube kann ein mit einer Sputterstrom-Versorgungseinrichtung verbundenes Kabel angeschlossen sein.

Ein weiterer konzentrisch zur Mittelachse 44 angeordneter Ringmagnet 13 befindet sich im Bereich des Außenumfangs der Kühlplatte 7 bzw. des Isolators 6. Der Magnet 13 ist ferromagnetisch ausgebildet und bildet somit den kompletten Magnetfeldeinschluß.

An den Ringmagneten 13 schließt sich ein Polschuh 14 an, der den Isolator 6, die Kühlplatte 7 sowie das Target 8 konzentrisch umgibt.

Der untere Teil des Polschuhs bildet einen pyramidenstumpfförmigen, sich nach unten bzw. in Richtung des Vakuumraums verjüngenden Polschuhteil 60. Der pyramidenstumpfförmige Polschuhteil 60 geht mit seinem Fußende in einen ringförmigen Flanschteil 61 über, der breiter ist als das freistehende Ende 62 des Polschuhs. Der Flanschteil 61 des Polschuhs 14 weist die eine Seitenwand 63 bzw. Stirnfläche auf, die Teil des sich pyramidenstumpfförmig verjüngenden Polschuhteils 60 ist. Am unteren Ende des Polschuhs können zwei mit Abstand zueinander angeordnete Ringflansche 61 angebracht sein, die eine Ringkammer 59 bilden.

Ist ein vierter Ringmagnet 47 konzentrisch zur Mittelachse 44 aufgenommen, dann können die Ringflansche 61 entfallen.

Zwischen der Stirnseite des Endes 62 des Polschuhs 14 und der geneigt verlaufenden Seitenwand 63 des sich pyramidenstumpfförmig verjüngenden Polschuhteils 60 befindet sich ein Winkel α, der zwischen 10° und 60° bzw. 20° und 50° bzw. 25° und 45° groß sein kann und der auf vorteilhafte Weise den Verlauf der Magnetfeldlinien beeinflußt.

Im Bereich der Mittelachse 44 der Zerstäubungskathode 2 befindet sich eine Bohrung 67, die sich durch die gesamte Vorrichtung erstreckt und die zur Aufnahme einer Hohlschraube 20 dient, die mit ihrem unteren Flanschteil 54 gegen einen am Target 8 vorgesehenen Flanschteil 53 gedrückt oder geschraubt wird.

An die Hohlschraube 20 schließt sich in axialer Richtung berührungsfrei das Joch 5 mit einer Jochplatte 21 an.

Auf der Rückseite des Jochs 5 ist ein Kühlkopf mit einem Flansch 22 befestigt, der in axialer Richtung durch die Jochplatte 21 sowie durch die Hohlschraube 20 bis zur Targetvorderseite reicht und die Hohlschraube 20 nicht berührt. Der Flansch 22 des Kühlfingers 69 mit einem sich daran anschließenden, zylinderförmigen Teil bildet eine zylinderförmige Bohrung 70 zur Aufnahme des in der Zeichnung nicht dargestellten Leitungsrohrs, das an eine Kühlwasserleitung angeschlossen ist.

An die Stirnseite bzw. an das untere Ende des Flanschs 22 des Kühlfingers 69 ist mittels einer Schraube 25 eine Mittelmaske bzw. eine Mittelanode 26 lösbar angeschlossen. Die Mittelanode reicht bis in die zentrische Vertiefung des Targets 8, welches an der Vorderseite des Targets vorgesehen ist, und bildet mit ihrem unteren Ende mit einer Außenanode 4 bzw. Außenmaske eine ringförmige Fläche für die Maskierung des Substrats 27.

Wie aus Fig. 1 hervorgeht, weist die Schraube 20 das Flanschelement 54 auf, das den am Target 8 vorgesehenen Flanschteil 53 gegen die Vorderseite der Kühlplatte 7 drückt. Auf diese Weise entfällt die sonst übliche Aufbondung des Targets, welches jederzeit leicht ausgewechselt werden kann. Ferner ist es möglich, das Target über Schrauben mit dem Kühlflansch zu verbinden.

Wie aus Fig. 1 hervorgeht, sind die beiden auf der Targetrückseite vorgesehenen Ringmagneten 9 und 42 vorzugsweise auf der gleichen Querebene angeordnet. Der innere Ringmagnet 9 ist im Bereich des Außenumfangs 56 der Mittelmaske bzw. Mittelanode 26 bzw. des Kühlfingers 69 oder näher zur Mittelachse 44 oder im Bereich des Außenumfangs der hohlförmigen Schraube 20 zur Aufnahme des Kühlfingers 69 angeordnet. Der äußere Ringmagnet 42 befindet sich im Randbereich bzw. im Bereich des Außenumfangs 55 des Targets 8.

Etwas oberhalb der beiden Ringmagneten 9 und 42 befindet sich der Ringmagnet 13, der auf dem Joch 5 angeordnet sein kann. Der Ringmagnet 13 kann aus zahlreichen einzelnen, ringförmig angeordneten Magneten gebildet sein.

Je nach Ausführung des Targets, das beispielsweise als Aluminium-Target oder als Gold-Target ausgebildet sein kann, kann ein vierter Ringmagnet 47 im Bereich des unteren Endes des Außenumfangs des Targets 8 vorgesehen sein.

Alle Ringmagneten 9, 13, 42 und 47 sind rotationssymmetrisch mit Bezug auf die Mittelachse 44 des Targets 8 angeordnet. In vorteilhafter Weise liegen auch die beiden inneren Ringmagneten 9 und 42 innerhalb des Außendurchmessers bzw. des Außenumfangs 55 des Targets 8.

Wie aus Fig. 1 hervorgeht, weist der äußere Ringmagnet 13 einen größeren Abstand zur Targetrückseite auf als die beiden inneren Ringmagneten 9 und 42.

Wird beispielsweise das Target als Aluminium-Target ausgebildet, so ist es vorteilhaft, wenn die Dicke D₁ des Targets 8 an seinem äußeren Randbereich größer ist als die Dicke D₂. Hierdurch erhält das Target 8 einen gemäß Fig. 1 geneigt verlaufenden Targetoberflächenabschnitt 49 und einen sich daran anschließenden, parallel zur Targetrückseite oder senkrecht zur Achse 44 verlaufenden Targetoberflächenabschnitt 50.

Setzt man ein Aluminium-Target ein, so wird bei Verwendung zweier Doppelringmagneten an der Rückseite des Targets auch bei sehr kompakter Bauweise das Magnetfeld abgeflacht (vgl. hierzu die Magnetfeldlinien 71 auf der rechten Seite des Targets 8). Würde man beispielsweise die beiden Doppelmagneten weglassen, so hätten die Magnetfeldlinien 71' einen sehr ungünstigen Verlauf, d. h. sie würden fast senkrecht in das Joch 5 eintreten. Auf der rechten Seite gemäß Fig. 1 haben die Feldlinien 71 einen konvexen bzw. abgeflachten oder in etwa parallelen Verlauf zur Targetrückseite. Dies wird in vorteilhafter Weise durch die beiden an der Targetrückseite vorgesehenen Doppelringmagneten 9 und 42 bewirkt, die zur Feldlinienverstärkung beitragen. Eine derartige Anordnung der Ringmagneten 9 und 42 eignet sich insbesondere bei einem nichtferromagnetischen Metalltarget, z. B. einem Aluminium-Target. Durch die doppelte Ausführung der beiden Ringmagneten wird eine sehr kompakte Bauweise der gesamten Vorrichtung erreicht und eine Kurzschlußgefahr weitgehend ausgeschlossen. Die beiden Ring- bzw. Gegenmagneten 9 und 42 verstärken also die Magnetfeldlinien, damit sie den in Fig. 1 auf der rechten Seite dargestellten Verlauf einnehmen können.

Wie aus Fig. 1 hervorgeht, ist der Abstand A zwischen der Stirnfläche der Kühlplatte 7 und der Unterkante der Mittelmaske und/oder Anode 26 größer als die Dicke D₁ des Targets 8 bzw. der Abstand P zwischen Targetrückseite 40 und dem spitzförmig hervorstehenden Polschuhteil 62.

Ein mittleres bzw. im Bereich der Mittelachse 44 liegendes, spitzförmiges Targetteil 51 ist mit Bezug auf das äußere Targetteil 52 zurückgesetzt.

Setzt man beispielsweise ein Target mit geringer Elektronenemissionsrate bzw. ein Gold-Target ein, so ist es vorteilhaft, wenn das Magnetfeld im Bereich der Targetoberfläche verstärkt wird, weil ein Gold-Target eine wesentlich andere Sputtereigenschaft hat als ein Aluminium-Target. Der im Bereich des Außenumfangs des Targets 8 und in den Polschuhen 14 vorgesehene Ringmagnet 47 liegt im Bereich oder auch etwas unterhalb der Targetoberfläche 41, die die Targetoberflächenabschnitte 49 und 50 aufweist, und dient zur Verstärkung des Magnetfeldes im Bereich der Targetoberfläche 41, so daß auch bei dieser Anordnung die Magnetfeldlinien nicht senkrecht oder annähernd senkrecht in das Joch 5 eintreten. Dieser relativ große Magnet 47 liegt in Richtung des Hauptmagnetfeldes und trägt zur Verstärkung des Magnetflusses bei. In diesem Fall können die Flansche bzw. Stege 61 des Polschuhteils 62 entfallen. Die unterbrochene Linie 72 deutet die Lage einer alternativen Targetfläche an, wenn sich der Ringmagnet 47 über die Targetfläche hinauserstrecken soll.

Da bei Gold-Sputtering eine geringere Elektronen-Emission auftritt, wäre ohne den relativ großen Ringmagneten in der Nähe der Targetoberfläche 41 eine deutlich höhere Spannung von z. B. 2.000 V erforderlich, um eine nennenswerte Leistung zu erzielen. Durch die vorteilhafte Anbringung des Ringmagneten 47 kann das Magnetfeld verstärkt und die Plasma-Impedanz reduziert werden.

Die in Fig. 1 dargestellten Ringmagneten 9, 13, 42 sind alle gleich gepolt, wobei Norden jeweils mit Bezug auf Fig. 1 nach unten gerichtet ist.

## Patentansprüche

1. Vorrichtung zur Kathodenzerstäubung für die Herstellung von Schichten auf einem Substrat (27) mittels einer in einer Vakuumkammer einbringbaren Zerstäubungskathode (2), die mit Bezug auf die Mittelachse (44) der Zerstäubungskathode (2) konzentrisch angeordnete Polschuhe (14) mit zugeordneten Magneten bzw. Ringmagneten (13) zur Ausbildung eines Magnetron-Magnetfeldes, ein Target (8), dessen Oberfläche (41, 72) mit Bezug auf die Targetrückseite (40) zumindest teilweise geneigt verläuft, und im Bereich der Targetrückseite (40) einen inneren Ringmagneten (9) aufweist, **dadurch gekennzeichnet, daß** im Bereich der Targetrückseite (40) neben dem ersten inneren Ringmagneten (9) mindestens ein zweiter äußerer, im Durchmesser größerer Ringmagnet (42) vorgesehen ist.

2. Vorrichtung nach Anspruch 1, **dadurch gekennzeichnet, daß** die beiden im Bereich der Targetrückseite vorgesehenen Ringmagneten (9, 42) auf der gleichen Querebene angeordnet sind.

3. Vorrichtung nach Anspruch 1 oder 2, **dadurch gekennzeichnet, daß** der innere Ringmagnet (9) im Bereich des Außenumfangs (56) der Mittelmaske bzw. Mittelanode (26) bzw. eines Kühlfingers und der äußere Ringmagnet (42) im Randbereich bzw. im Bereich des Außenumfangs (55) des Targets (8) vorgesehen ist.

4. Vorrichtung nach Anspruch 1, 2 oder 3, **dadurch gekennnzeichnet,** daß neben den beiden inneren Ringmagneten (9, 42) ein dritter, die beiden Ringmagneten (9, 42) umgebender Ringmagnet (13) vorgesehen ist.

5. Vorrichtung nach einem oder mehreren der vorhergehenden Ansprüche, **dadurch gekennzeichnet, daß** der dritte Ringmagnet (13) an eine Seite bzw. an die untere Seite des Joches (5) angrenzt.

6. Vorrichtung nach einem der Ansprüche 1 bis 5, **dadurch gekennzeichnet, daß** alle Ringmagneten (9, 13, 42) rotationssymmetrisch mit Bezug auf die Mittelachse (44) des Targets angeordnet sind.

7. Vorrichtung nach einem oder mehreren der vorhergehenden Ansprüche, **dadurch gekennzeichnet, daß** die beiden inneren Ringmagneten (9, 42) in sich in der Kühlplatte (7) befindenden Ringnuten (65, 66) vorgesehen sind.

8. Vorrichtung nach einem oder mehreren der vorhergehenden Ansprüche, **dadurch gekennzeichnet, daß** der äußere Ringmagnet (13) im Bereich des Polschuh-Durchmessers zwischen dem Joch (5) und dem oberen Teil des Polschuhs (14) vorgesehen ist.

9. Vorrichtung nach einem oder mehreren der vorhergehenden Ansprüche, **dadurch gekennzeichnet, daß** die beiden inneren Ringmagneten (9, 42) innerhalb des Außendurchmessers bzw. des Außenumfangs (55) des Targets (8) liegen.

10. Vorrichtung nach einem oder mehreren der vorhergehenden Ansprüche, **dadurch gekennzeichnet, daß** der äußere Ringmagnet (13) einen größeren Abstand zur Targetrückseite (40) aufweist als die beiden inneren Ringmagneten.

11. Vorrichtung nach einem oder mehreren der vorhergehenden Ansprüche, **dadurch gekennzeichnet, daß** die Dicke D₁ des Targets (8) an seinem äußeren Randbereich größer ist als die Dicke D₂ im inneren Randbereich des Targets (8).

12. Vorrichtung nach einem oder mehreren der vorhergehenden Ansprüche, **dadurch gekennzeichnet, daß** zwischen dem inneren und dem äußeren Randbereich des Targets (8) eine geneigt verlaufende Targetoberfläche (49) und eine parallel zur Targetrückseite (40) verlaufende Targetoberfläche (50) vorgesehen ist.

13. Vorrichtung nach einem oder mehreren der vorhergehenden Ansprüche, **dadurch gekennzeichnet, daß** die geneigt verlaufende Targetoberfläche im inneren Randbereich des Targets (8) und die parallel verlaufende Targetoberfläche (50) im äußeren Randbereich des Targets (8) vorgesehen ist.

14. Vorrichtung nach einem oder mehreren der vorhergehenden Ansprüche, **dadurch gekennzeichnet, daß** die geneigt verlaufende Targetoberfläche (49) und die parallel verlaufende Targetoberfläche (50) zwischen einem inneren und einem äußeren, spitzförmig hervorstehenden Targetteil (51, 52) vorgesehen sind.

15. Vorrichtung nach einem oder mehreren der vorhergehenden Ansprüche, **dadurch gekennzeichnet, daß** am inneren Randbereich des Targets (8) ein ringförmiges, konzentrisch zur Mittelachse (44) verlaufendes Flanschteil (53) vorgesehen ist, das zwischen der Oberfläche der Kühlplatte (7) und dem Flanschteil (54) einer Befestigungsvorrichtung (20) eingeklemmt ist, die mit dem Target (8) fest bzw. lösbar verbunden ist.

16. Vorrichtung nach einem oder mehreren der vorhergehenden Ansprüche, **dadurch gekennzeichnet, daß** ein weiterer Ringmagnet (47) vorgesehen ist, der den Außenumfang (55) des Targets (8) umgibt.

17. Vorrichtung nach Anspruch 16, **dadurch gekennzeichnet, daß** der weitere Ringmagnet (47) unterhalb der an der Targetrückseite (40) bzw. in deren Bereich vorgesehenen Ringmagneten (9 bzw. 13) vorgesehen ist.

18. Vorrichtung nach einem der Ansprüche 1 bis 17, **dadurch gekennzeichnet, daß** der im Bereich des Außenumfangs (55) des Targets (8) vorgesehene Ringmagnet (47) etwas oberhalb oder unterhalb der unteren Begrenzung (57) der Targetoberfläche (50) vorgesehen ist.

19. Vorrichtung zur Kathodenzerstäubung für die Herstellung von Schichten auf einem Substrat (27) mittels einer in einer Vakuumkammer einbringbaren Zerstäubungskathode (2), die mit Bezug auf die Mittelachse (44) der Zerstäubungskathode (2) konzentrisch angeordnete Magneten bzw. Ringmagneten (9, 13), Polschuhe (14) und ein Target (8) aufweist, dessen Oberfläche (41, 72) mit Bezug auf die Targetrückseite (40) zumindest teilweise geneigt verläuft, insbesondere nach einem der Ansprüche 1 bis 18, **dadurch gekennzeichnet, daß** der Polschuh (14) einen unteren Abschnitt mit einem Ringraum oder einer Ringnut (59) aufweist

20. Vorrichtung nach Anspruch 19, wobei der untere Abschnitt des Polschuhs (14) zwei zueinander beabstandete Flansche (61) oder Stege aufweist, die den Ringraum (59) begrenzen.

21. Vorrichtung nach Anspruch 20, wobei die Flansche (61) parallel zur Targetrückseite (40) verlaufen.

22. Vorrichtung nach einem der Ansprüche 1 bis 21, **dadurch gekennzeichnet, daß** das untere Ende (58) des Polschuhs (14) einen größeren Abstand (P) zur Targetrückseite (40) aufweist als das untere Ende (62) des Targets bzw. die Targetoberfläche (50).

23. Vorrichtung nach einem der Ansprüche 1 bis 22, **dadurch gekennzeichnet, daß** der untere Teil des Polschuhs (14) zum Außenumfang der Polschuhe (14) aus einem sich pyramidenstumpfförmig verjüngenden Polschuhteil (60) besteht.

24. Vorrichtung nach einem der Ansprüche 20 bis 23, **dadurch gekennzeichnet, daß** der sich pyramidenstumpfförmig verjüngende Polschuhteil (60) in den Flanschteil (61) übergeht, der breiter ist als das freistehende Ende (62) des Polschuhs (14).

25. Vorrichtung nach einem der Ansprüche 1 bis 24, **dadurch gekennzeichnet, daß** zwischen der Stirnfläche des Endes (62) des Polschuhs (14) und der geneigt verlaufenden Seitenwand bzw. Stirnfläche (63) des sich pyramidenstumpfförmig verjüngenden Polschuhteils (60) ein Winkel (α) eingeschlossen ist, der zwischen 10° und 50° bzw. zwischen 25° und 45° groß ist.

26. Vorrichtung nach einem der Ansprüche 1 bis 25, **dadurch gekennzeichnet, daß** die Oberfläche bzw. Ringfläche (63) des Polschuhteils (60) auf der gleichen geneigt verlaufenden Ebene liegt wie die geneigt verlaufende Oberfläche bzw. Ringfläche des spitzförmigen Targetteils (52).

27. Vorrichtung nach einem der Ansprüche 19 bis 26, wobei in dem Ringraum (59) ein Ringmagnet (47) angeordnet ist.

28. Vorrichtung nach einem der Ansprüche 16 bis 27, **dadurch gekennzeichnet, daß** der im Bereich des Außenumfangs (55) des Targets (8) vorgesehene Ringmagnet (47) etwas unterhalb oder außerhalb der unteren Begrenzung (57) der Targetoberfläche (50) vorgesehen ist, die parallel zur Targetrückseite (40) des Targets verläuft.

29. Vorrichtung nach einem der Ansprüche 16 bis 28, **dadurch gekennzeichnet, daß** der im Bereich des Außenumfangs (55) des Targets (8) vorgesehene Ringmagnet (47) etwas unterhalb oder außerhalb der unteren Begrenzung (58) der Polschuhe (14) endet.

30. Vorrichtung nach einem der Ansprüche 16 bis 29, **dadurch gekennzeichnet, daß** der Ringmagnet (47) konzentrisch zur Mittelachse (44) des Targets (8) angeordnet ist.

## Claims

1. A device for cathode sputtering for producing coatings on a substrate (27) by means of a sputtering cathode (2), which can be introduced into a vacuum chamber, said device comprising - concentrically arranged with respect to the center axis (44) of the sputtering cathode (2) - pole shoes (14) with associated magnets or ring magnets (13) for forming a magnetron magnetic field, a target (8) whose surface (41, 72) extends at least partially inclined with respect to the back of the target (40), and an inner ring magnet (9) in the region of the back of the target (40), **characterised in that** in the region of the back of the target (40), besides the first inner ring magnet (9), at least a second outer ring magnet (42) having a larger diameter is provided.

2. The device according to claim 1, **characterised in that** the two ring magnets (9, 42) provided in the area of the back of the target are arranged on a common plane transverse to the center axis.

3. The device according to claim 1 or 2, **characterised in that** the inner ring magnet (9) is located in the area of the exterior circumferential surface (56) of the center mask or center anode (26) or a cooling finger and the outer ring magnet (42) is located at the edge or in the area of the exterior circumference (55) of the target (8).

4. The device according to claim 1, 2 or 3, **characterised in that** a third ring magnet (13) surrounding the two ring magnets (9, 42) is provided besides the two inner ring magnets (9, 42).

5. The device according to one or a plurality of the preceding claims, **characterised in that** the third ring magnet (13) adjoins one part or the lower part of the yoke (5).

6. The device according to any one of claims 1 to 5, **characterised in that** all ring magnets (9, 13, 42) are mounted to be axially symmetrical with respect to the center axis (44) of the target.

7. The device according to one or a plurality of the preceding claims, **characterised in that** the two inner ring magnets (9, 42) are provided in annular grooves (65, 66) being provided in the cooling plate (7).

8. The device according to one or a plurality of the preceding claims, **characterised in that** the outer ring magnet (13) is provided in the area of the pole shoe diameter between the yoke (5) and the upper part of the pole shoe (14).

9. The device according to one or a plurality of the preceding claims, **characterised in that** the two inner ring magnets (9, 42) are located within the outside diameter or the exterior circumference (55) of the target (8).

10. The device according to one or a plurality of the preceding claims, **characterised in that** the outer ring magnet (13) is disposed at a greater distance from the back of the target (40) than are the two inner ring magnets.

11. The device according to one or a plurality of the preceding claims, **characterised in that** the thickness D₁ of the target (8) is larger at its outer edge area than the thickness D₂ in its inner edge area of the target (8).

12. The device according to one or a plurality of the preceding claims, **characterised in that** an inclined extending target surface (49) and a target surface (50) extending parallel to the back surface of the target (40) are provided between the inner and the outer edge areas of the target (8).

13. The device according to one or a plurality of the preceding claims, **characterised in that** the inclined extending target surface is located in the inner edge area of the target (8) and the target surface (50) extending parallel in the outer edge area of the target (8).

14. The device according to one or a plurality of the preceding claims, **characterised in that** the inclined extending target surface (49) and the target surface (50) extending parallel are provided between an inner and an outer projecting sharp edged target portion (51, 52).

15. The device according to one or a plurality of the preceding claims, **characterised in that** at the inner edge area of the target (8), a ring-shaped flange element (53) extending concentrically with the center axis (44) is provided, said ring-shaped flange element (53) being clamped between the surface of the cooling plate (7) and the flange element (54) of a fastening device (20), which is fixedly or detachably connected with the target.

16. The device according to one or a plurality of the preceding claims, **characterised in that** a further ring magnet (47) surrounding the exterior circumference (55) of the target (8) is provided.

17. The device according to claim 16, **characterised in that** the further ring magnet (47) is located below the ring magnets (9 or 13, respectively) provided at the back of the target (40) or within its area.

18. The device according to any one of claims 1 to 17, **characterised in that** the ring magnet (47) arranged in the area of the exterior circumference (55) of the target (8) is located slightly above or below the lower extremity (57) of the target surface (50).

19. A device for cathode sputtering for producing coatings on a substrate (27) by means of a sputtering cathode (2), which can be introduced into a vacuum chamber, said device comprising - concentrically arranged with respect to the center axis (44) of the sputter cathode (2) - magnets or ring magnets (9, 13), pole shoes (14) and a target (8) whose surface (41, 72) extends at least partially inclined with respect to the back of the target (40), particularly according to any one of claims 1 to 18, **characterised in that** the pole shoe (14) comprises a lower part with an annular chamber or annular groove (59).

20. The device according to claim 19, wherein the lower part of the pole shoe (14) has two spaced apart flanges (61) or bars delimiting the annular chamber (59).

21. The device according to claim 20, wherein the flanges (61) extend parallel to the back of the target (40).

22. The device according to any one of claims 1 to 21, **characterised in that** the lower end (58) of the pole shoe (14) is disposed at a greater distance (P) from the back of the target (40) than is the lower end (62) of the target or the target surface (50).

23. The device according to any one of claims 1 to 22, **characterised in that** the lower part of the pole shoe (14) is constituted by a pole shoe element (60) which tapers to the exterior circumference of the pole shoe (14) in the form of a truncated cone.

24. The device according to any one of claims 20 to 23, **characterised in that** the pole shoe element (60) tapering in the form of a truncated cone makes a transition into the flange element (61) which is wider than the free-standing end (62) of the pole shoe (14).

25. The device according to any one of claims 1 to 24, **characterised in that** an angle α having a value between 10° and 50° or between 25° and 45° is formed between the front face of the end (62) of the pole shoe (14) and the inclined extending lateral wall or front face (63) of the pole shoe element (60) tapering in the form of a truncated cone.

26. The device according to any one of claims 1 to 25, **characterised in that** the surface or annular surface (63) of the pole shoe element (60) is located on the same inclined extending plane as the inclined extending surface or annular surface of the sharp edged target portion (52).

27. The device according to any one of claims 19 to 26, wherein a ring magnet (47) is arranged in the annular chamber (59).

28. The device according to any one of claims 16 to 27, **characterised in that** the ring magnet (47) located in the area of the exterior circumference (55) of the target (8) is provided slightly below or outside the lower extremity (57) of the target surface (50), which extends parallel to the back surface (40) of said target.

29. The device according to any one of claims 16 to 28, **characterised in that** the ring magnet (47) provided in the area of the exterior circumference (55) of the target (8) ends slightly below or outside the lower extremity (58) of the pole shoes (14).

30. The device according to any one of claims 16 to 29, **characterised in that** the ring magnet (47) is concentrically arranged with respect to the center axis (44) of the target (8).

## Revendications

1. Dispositif de pulvérisation cathodique pour la fabrication de couches sur un substrat (27) au moyen d'une cathode de pulvérisation (2) pouvant être introduite dans une chambre à vide, qui présente des patins polaires (14) disposés de façon concentrique par rapport à l'axe médian (44) de la cathode de pulvérisation (2) avec des aimants associés ou des aimants annulaires (13) associés pour la formation d'un champ magnétique de magnétron, une cible (8), dont au moins une partie de la surface (41, 72) est agencée de façon inclinée par rapport à la face arrière (40) de la cible et un aimant annulaire intérieur (9) dans la zone de la face arrière (40) de la cible, **caractérisé en ce qu'**au moins un second aimant annulaire (42) extérieur et plus grand en diamètre est prévu dans la zone de la face arrière (40) de la cible à côté du premier aimant (9) annulaire intérieur.

2. Dispositif selon la revendication 1, **caractérisé en ce que** les deux aimants annulaires (9, 42) prévus dans la zone de la face arrière de la cible sont disposés sur le même plan transversal.

3. Dispositif selon la revendication 1 ou 2, **caractérisé en ce que** l'aimant annulaire (9) intérieur est prévu dans la zone du pourtour extérieur (56) du masque central ou de l'anode centrale (26) ou d'un doigt de refroidissement et l'aimant annulaire (42) extérieur est prévu dans la zone périphérique ou dans la zone du pourtour extérieur (55) de la cible (8).

4. Dispositif selon la revendication 1, 2 ou 3, **caractérisé en ce qu'**il est prévu en plus des deux aimants annulaires (9, 42) intérieurs, un troisième aimant annulaire (13) entourant les deux aimants annulaires (9, 42).

5. Dispositif selon l'une quelconque ou plusieurs des revendications précédentes, **caractérisé en ce que** le troisième aimant annulaire (13) est contigu à un côté ou au côté inférieur de la culasse (5).

6. Dispositif selon l'une quelconque des revendications 1 à 5, **caractérisé en ce que** tous les aimants annulaires (9, 13, 42) présentent une symétrie de révolution par rapport à l'axe médian (44) de la cible.

7. Dispositif selon l'une quelconque ou plusieurs des revendications précédentes, **caractérisé en ce que** les deux aimants annulaires (9, 42) intérieurs sont prévus dans des rainures annulaires (65, 66) qui se trouvent dans la plaque de refroidissement (7).

8. Dispositif selon l'une quelconque ou plusieurs des revendications précédentes, **caractérisé en ce que** l'aimant annulaire (13) extérieur est prévu dans la zone diamétrale de patin polaire entre la culasse (5) et la partie supérieure du patin polaire (14).

9. Dispositif selon l'une quelconque ou plusieurs des revendications précédentes, **caractérisé en ce que** les deux aimants annulaires (9, 42) intérieurs sont disposés à l'intérieur du diamètre extérieur ou du pourtour extérieur (55) de la cible (8).

10. Dispositif selon l'une quelconque ou plusieurs des revendications précédentes, **caractérisé en ce que** l'aimant annulaire (13) extérieur présente une distance au côté arrière (40) de la cible plus grande que les deux aimants annulaires intérieurs.

11. Dispositif selon l'une quelconque ou plusieurs des revendications précédentes, **caractérisé en ce que** l'épaisseur D₁ de la cible (8) sur sa zone périphérique extérieure est supérieure à l'épaisseur D₂ dans la zone périphérique intérieure de la cible (8).

12. Dispositif selon l'une quelconque ou plusieurs des revendications précédentes, **caractérisé en ce qu'**il est prévu entre la zone périphérique intérieure et la zone périphérique extérieure de la cible (8) une surface (49) de cible disposée de façon inclinée et une surface (50) de cible agencée parallèlement au côté arrière (40) de la cible.

13. Dispositif selon l'une quelconque ou plusieurs des revendications précédentes, **caractérisé en ce que** la surface de cible agencée de façon inclinée est prévue dans la zone périphérique intérieure de la cible (8) et la surface (50) de cible agencée de façon parallèle dans la zone périphérique extérieure de la cible (8).

14. Dispositif selon l'une quelconque ou plusieurs des revendications précédentes, **caractérisé en ce que** la surface de cible (49) agencée de façon inclinée et la surface de cible (50) agencée de façon parallèle sont prévues entre une partie de cible intérieure et une partie de cible extérieure en forme de pointe (51, 52) débordante.

15. Dispositif selon l'une quelconque ou plusieurs des revendications précédentes, **caractérisé en ce qu'**il est prévu sur la zone périphérique intérieure de la cible (8) une partie de bride (53) de forme annulaire et disposée de façon concentrique par rapport à l'axe médian (44), qui est coincée entre la surface de la plaque de refroidissement (7) et la partie de bride (54) d'un dispositif de fixation (20), qui est relié de façon fixe ou amovible à la cible (8).

16. Dispositif selon l'une quelconque ou plusieurs des revendications précédentes, **caractérisé en ce qu'**il est prévu un autre aimant annulaire (47) qui entoure le pourtour extérieur (55) de la cible (8).

17. Dispositif selon la revendication 16, **caractérisé en ce que** l'autre aimant annulaire (47) est prévu au-dessous des aimants annulaires (9 et 13) prévus sur le côté arrière (40) de la cible ou dans sa zone.

18. Dispositif selon l'une quelconque des revendications 1 à 17, **caractérisé en ce que** l'aimant annulaire (47) prévu dans la zone du pourtour extérieur (55) de la cible (8) est prévu un peu au-dessus ou au-dessous de la limite inférieure (57) de la surface (50) de cible.

19. Dispositif de pulvérisation cathodique pour la fabrication de couches sur un substrat (27) au moyen d'une cathode de pulvérisation (2) pouvant être introduite dans une chambre à vide, qui présente des aimants ou des aimants annulaires (9, 13) disposés de façon concentrique par rapport à l'axe médian (44) de la cathode de pulvérisation (2), des patins polaires (14) et une cible (8) et dont une partie au moins de la surface (41, 72) supérieure est disposée de façon inclinée par rapport au côté arrière (40) de la cible, en particulier selon l'une quelconque des revendications 1 à 18, **caractérisé en ce que** le patin polaire (14) présente une partie inférieure avec un espace annulaire ou une rainure annulaire (59).

20. Dispositif selon la revendication 19, la partie inférieure du patin polaire (14) présentant deux brides (61) ou traverses espacées l'une de l'autre, qui délimitent l'espace annulaire (59).

21. Dispositif selon la revendication 20, les brides (61) étant parallèles à la face arrière (40) de la cible.

22. Dispositif selon l'une quelconque des revendications 1 à 21, **caractérisé en ce que** l'extrémité (58) inférieure du patin polaire (14) présente une distance (P) à la face arrière (40) de la cible plus grande que l'extrémité (62) inférieure de la cible ou la surface supérieure (50) de la cible.

23. Dispositif selon l'une quelconque des revendications 1 à 22, **caractérisé en ce que** la partie inférieure du patin polaire (14) est constituée d'une partie (60) de patin polaire qui se rétrécit en forme de pyramide tronquée vers le pourtour extérieur des patins polaires (14).

24. Dispositif selon l'une quelconque des revendications 20 à 23, **caractérisé en ce que** la partie (60) du patin polaire qui se rétrécit en forme de pyramide tronquée fait place à la partie de bride (61) qui est plus large que l'extrémité (62) isolée du patin polaire (14).

25. Dispositif selon l'une quelconque des revendications 1 à 24, **caractérisé en ce qu'**un angle (α) est formé entre la surface frontale de l'extrémité (62) du patin polaire (14) et la paroi latérale agencée de façon inclinée ou la surface frontale (63) de la partie (60) du patin polaire qui se rétrécit en forme de pyramide tronquée, lequel angle est compris entre 10 et 50° ou entre 25 et 45°.

26. Dispositif selon l'une quelconque des revendications 1 à 25, **caractérisé en ce que** la surface ou la surface annulaire (63) de la partie (60) du patin polaire est disposée sur le même plan incliné que la surface inclinée ou la surface annulaire inclinée de la partie (52) de cible de forme pointue.

27. Dispositif selon l'une quelconque des revendications 19 à 26, un aimant annulaire (47) étant disposé dans l'espace annulaire (59).

28. Dispositif selon l'une quelconque des revendications 16 à 27, **caractérisé en ce que** l'aimant annulaire (47) prévu dans la zone du pourtour extérieur (55) de la cible (8) est prévu un peu au-dessous ou à l'extérieur de la limite (57) inférieure de la surface de cible (50), qui est parallèle à l'arrière (40) de la cible.

29. Dispositif selon l'une quelconque des revendications 16 à 28, **caractérisé en ce que** l'aimant annulaire (47) prévu dans la zone du pourtour extérieur (55) de la cible (8) se termine un peu au-dessous ou à l'extérieur de la limite (58) inférieure des patins polaires (14).

30. Dispositif selon l'une quelconque des revendications 16 à 29, **caractérisé en ce que** l'aimant annulaire (47) est disposé de façon concentrique par rapport à l'axe médian (44) de la cible (8).
